# EUROPEAN PATENT SPECIFICATION

(11) **EP 3 540 443 B1**
(45) Date of publication and mention of the grant of the patent: **30.08.2023**
(21) Application number: 18162202.8
(22) Date of filing: 16.03.2018
(51) Int. Cl.: G01N 35/04, B01L 3/00, B01L 9/06, B65G 54/02

(54) **LABORATORY SYSTEM, LABORATORY SAMPLE DISTRIBUTION SYSTEM AND LABORATORY AUTOMATION SYSTEM**
LABORSYSTEM, LABORPROBENVERTEILUNGSSYSTEM UND LABORAUTOMATIONSSYSTEM
SYSTÈME DE LABORATOIRE, SYSTÈME DE DISTRIBUTION D'ÉCHANTILLONS DE LABORATOIRE ET SYSTÈME D'AUTOMATISATION DE LABORATOIRE

(43) Date of publication of application: 18.09.2019
(73) Proprietor: Roche Diagnostics GmbH, 68305 Mannheim (DE); F. Hoffmann-La Roche AG, 4070 Basel (CH)
(72) Inventor: KOPP, Martin, 6333 Huenenberg See (CH); GUTMANN, Oliver, 8800 Thalwil (CH); SCHMITT, Norbert, 6004 Luzern (CH)
(74) Representative: Patentanwälte Ruff, Wilhelm, Beier, Dauster & Partner mbB

(56) References cited:
- EP-A1- 2 589 968
- EP-A1- 3 095 739
- US-A1- 2015 276 782
- US-A1- 2016 077 120
- US-B2- 9 248 982

## Description

### TECHNICAL FIELD AND PRIOR ART

The invention relates to a laboratory system, a laboratory sample distribution system comprising such a laboratory system and a laboratory automation system comprising such a laboratory system and/or such a laboratory sample distribution system.

Known laboratory automation systems typically comprise a number of analytical stations and a laboratory sample distribution in order to move samples contained by laboratory sample containers carried by sample container carriers to the number of analytical stations. Such a laboratory automation system is shown in document WO 2013/064662 A1. The laboratory automation system comprises a memory device being adapt to store matching pairs of a unique identification (ID) corresponding to a sample container carrier and a laboratory sample container ID being carried by the sample container carrier, making it possible to control and track laboratory sample containers over a processing path.

US 9,248,982 B2 concerns cases where a laboratory product may be removed from a laboratory product transport element. For example, a mechanical sensor may become active when there is a laboratory product in a holder. When a laboratory product is removed, the mechanical sensor may deactivate, thereby sending a signal indicating that the laboratory product has been removed from the holder. In some cases, an RFID-tag or other indicator may be coupled to the laboratory product. The laboratory product transport element may be configured to read the tag or indicator to determine its presence in the holder and can provide an error signal when it no longer identifies that the tag or indicator in the holder.

### SUMMARY OF THE INVENTION

It is the object of the invention to provide a laboratory system, which enables to ensure integrity of a logic assignment of an analytical result to a sample. It is a further object of the invention to provide a laboratory sample distribution system comprising such a laboratory system and a laboratory automation system comprising such a laboratory system and/or such a laboratory sample distribution system.

These objects are solved by a laboratory system according to claim 1, a laboratory sample distribution system according to claim 7 and a laboratory automation system according to claim 9. Preferred embodiments are defined in the dependent claims.

The invention relates to a laboratory system for a laboratory automation system. The laboratory system comprises a sample container carrier. The sample container carrier is adapted to carry a laboratory sample container and comprises a removal detector. The removal detector is adapted to interact with the laboratory sample container to detect, in particular to automatically detect, a removal or an unloading, respectively, of the carried laboratory sample container from the sample container carrier. Furthermore, the laboratory system is adapted to determine, in particular to automatically determine, based on or in dependence of, respectively, the detected removal, that a before valid logic assignment of the sample container carrier to the carried laboratory sample container is invalid.

In particular the before by the sample container carrier carried laboratory sample container may be unintentionally interchanged, in particular by failure or manipulation, with another laboratory sample container, for which the logic assignment may be invalid. Thereby, a logic assignment of an analytical result of another sample contained by the carried another laboratory sample container to a sample contained by the before carried laboratory sample container indirectly by use of the logic assignment of the sample container carrier to the before carried laboratory sample container may be wrong. So far it was possible, that this wrong logic assignment may have remained undetected.

Now the removal detector of the sample container carrier enables to detect a possible interchange by detecting the removal. Since the laboratory sample container may be interchanged, it is determined based on the detected removal, that the before valid logic assignment of the sample container carrier to the carried laboratory sample container is invalid. Thereby, a risk of a wrong logic assignment of an analytical result to a sample is reduced or even eliminated. In other words: the laboratory system enables to ensure integrity of a logic assignment of an analytical result to a sample and thereby to a corresponding patient.

In detail the laboratory sample container may be designed as a tube and/or may have an opening at an upper, top and/or face end. Furthermore, the laboratory sample container may be made of glass or transparent plastic or any other, in particular somewhat, solid material. Moreover, the laboratory sample container or its opening, respectively, may be closed by a closure or a cap. The closure may comprise rubber and/or plastic or may completely consist of rubber and/or plastic. Further, the closure may be embodied as a foil, in particular a flexible foil, or film or tape or as a lid, in particular as a rigid lid.

Furthermore, the laboratory sample container may be adapted to contain a sample. The sample may be a blood sample, a serum sample, a plasma sample, a urine sample, a CFS sample, a body sample, a water sample or a chemical sample. In particular the sample may be a liquid. The laboratory sample container or its opening, respectively, may be open for processing, in particular analyzing, the sample, if present, contained by the laboratory sample container.

Moreover, the laboratory sample container may comprise a, in particular unique, ID. The ID may be representative for the sample, if present, contained by the laboratory sample container. In particular the ID may comprise or be a barcode. The ID of the laboratory sample container may be denoted as container ID.

However, it may be too complicated, in particular too time-consuming, or even impossible to directly use the laboratory sample container, in particular its container ID, if present, for identification of the sample in the laboratory automation system all the time and/or in each situation, in particular in a workflow of the laboratory automation system.

Instead of container identification the sample container carrier, in particular an ID of the sample container carrier, may be directly used for identification of the sample, if present, contained by the carried laboratory sample container in the laboratory automation system.

In particular the sample container carrier may be adapted to comprise a, in particular unique, ID. The ID may be representative for the sample container carrier and/or the carried laboratory sample container and/or the sample, if present, contained by the carried laboratory sample container. The ID of the sample container carrier may be denoted as carrier ID.

The logic assignment may be an assignment of the carrier ID to the container ID. Further, the assignment may be denoted as link or association. Valid may be denoted as correct. Invalid may be denoted as incorrect.

Furthermore, the sample container carrier does not have to comprise any means for identification of the, in particular carried, laboratory sample container and/or the sample, if present, contained by the laboratory sample container. In particular the sample container carrier does not have to comprise a reader for reading the container ID.

Moreover, the sample container carrier may be adapted or embodied to carry only one or a single laboratory sample container. The sample container carrier may be denoted as single sample container carrier. Further, the sample container carrier may be adapted to move the carried, in particular open, laboratory sample container in a laboratory sample distribution system and/or in the laboratory automation system.

In particular the sample container carrier may be adapted to determine based on the detected removal, that the before valid logic assignment of the sample container carrier to the carried laboratory sample container is invalid.

The removal detector may be adapted to interact with the laboratory sample container contactless or by contact, in particular by contacting the laboratory sample container at an outside, in particular at a circumference, of the laboratory sample container. In particular the removal detector may be adapted to detect a presence of the laboratory sample container. The removal detector may be denoted as presence detector. Furthermore, the removal detector may be arranged in a bottom or a laboratory sample container adapter of the sample container carrier.

The sample container carrier comprises a memory element. The memory element is adapted to store, in particular to automatically store, information based on the detected removal, information based on, that the logic assignment is valid, and/or information based on, that the logic assignment is invalid. This may enable or allow, that information does not have to be transmitted on or at detection or determination, but may be transmitted at a later time. In particular the memory element may be a re-writable and/or non-volatile memory element. The memory element may be an electric memory element. In particular the memory element may comprise a capacitor, a flip-flop or a latch, respectively, a microcontroller and/or a semiconductor memory. The memory element may be have two, in particular stable, states and may be used to store state information. In particular a first state may be, that the logic assignment is valid, and a from the first different, second state may be, that the logic assignment is invalid. Information based on the detected removal may be a time of or a time period since the detected removal. The time or the time period may be compared with a time or a time period since the last, in particular intentional, removal of a laboratory sample container from the sample container carrier or since a, in particular intentional, loading of the laboratory sample container on the sample container carrier, in particular by the laboratory system or a control device of the laboratory system, respectively. Based on the comparison the laboratory system or its control device, if present, may determine, that the before valid logic assignment of the sample container carrier to the carried laboratory sample container is invalid. The control device may comprise or be an integrated circuit, a tablet computer, a smartphone or a computer. Information based on, that the logic assignment is valid, may be information about the laboratory sample container, in particular the container ID, if present, and/or the sample, if present, contained by the laboratory sample container. Based on the detected removal, the valid information may be deleted or changed, in particular such that the invalid information may be generated.

The sample container carrier comprises a receiver. The receiver is adapted to receive, in particular to automatically and/or wireless receive, information based on, that the logic assignment is valid, in particular from outside the sample container carrier, and to store the information on the memory element. In particular this may be denoted to arm the sample container carrier or its memory element, respectively. The receiver may be different from the removal detector. Additionally or alternatively the receiver may be an electric receiver and/or a wireless receiver, in particular a radio receiver, in particular comprising an antenna.

The sample container carrier comprises a transmitter. The transmitter is adapted to transmit, in particular to automatically and/or wireless transmit, information based on the detected removal, information based on, that the logic assignment is valid, and/or information, that the logic assignment is invalid, in particular to outside the sample container carrier. In particular the transmitter may be different from the removal detector. Additionally or alternatively the transmitter may be an electric transmitter and/or a wireless transmitter, in particular a radio transmitter, in particular comprising an antenna. Information may be such as described above in the context of the memory element. In particular if the valid information is deleted, the transmitter may be adapted not to transmit.

The sample container carrier comprises a transponder. The transponder comprises the transmitter and the receiver. Furthermore, the transponder is adapted to receive, in particular to automatically and/or wireless receive, an interrogation, in particular an interrogation signal or an interrogation wave, respectively, for the information, in particular by its receiver, and to transmit, in particular to automatically transmit, the information in response to the received interrogation, in particular by its transmitter. This may enable, that only the interrogated sample container carrier transmits. In particular the transponder may be different from the removal detector. Additionally or alternatively the transponder may be an electric transponder and/or a wireless transponder, in particular a radio transponder. The transmitter and the receiver may be combined, in particular they may be denoted as transceiver. The receiver may be embodied as described above. In particular the transponder may be embodied as a radio-frequency identification (RFID) label or tag.

The transponder is a near-field communication (NFC) transponder. This enables, that only the sample container carrier may be interrogated. In particular a communication range may be in the range from 1 centimeter (cm) to 10 cm, in particular from 2 cm to 8 cm, in particular from 3 cm to 6 cm, in particular 4 cm.

The receiver is adapted to collect, in particular to automatically collect, energy, in particular electrical energy and/or of the interrogation, and to supply, in particular to automatically supply, the sample container carrier, in particular its removal detector and/or its memory element, if present, with the collected energy. In particular the sample container carrier may be denoted as passive sample container carrier and/or power harvesting sample container carrier. In other words: the sample container carrier may be adapted to be only supplied by the collected energy. Further, in other words: the sample container carrier does not have to comprise an own power source, in particular an accumulator and/or a battery.

According to an embodiment of the invention the removal detector comprises a switch, in particular a microswitch, an optical sensor, a capacitive sensor, a pressure sensor, a temperature sensor, and/or a shape memory alloy being adapted to interact with the laboratory sample container to detect, in particular to automatically detect, a removal of the carried laboratory sample container from the sample container carrier. In particular the switch may be a mechanical switch, which may be depressed by the laboratory sample container, if present, and not depressed, if the laboratory sample container is absent, in particular by a spring.

According to an embodiment of the invention the laboratory system comprises a receiver station. The receiver station is adapted to receive, in particular to automatically and/or wireless receive, information based on the detected removal, information based on, that the logic assignment is valid, and/or information, that the logic assignment is invalid, from the sample container carrier. In particular the receiver station may be different from the sample container carrier. Additionally or alternatively the receiver station may be an electric receiver station and/or a wireless receiver station, in particular a radio receiver station, in particular comprising an antenna, in particular a RDIF receiver station and/or a NFC receiver station. In particular the receiver station may be adapted to transmit, in particular to automatically and/or wireless transmit, the interrogation. The receiver station may be denoted as reader station. Information may be such as described above in the context of the memory element. In particular if the valid information is deleted, the receiver station may not receive or not be able to read-out information. This enables or allows the receiver station to recognize, that the logic assignment is invalid.

According to an embodiment of the invention the laboratory system comprises a transmitter station. The transmitter station is adapted to transmit, in particular to automatically and/or wireless transmit, information, that the logic assignment is valid, to the sample container carrier. In particular this may be denoted to arm the sample container carrier or its memory element, if present, respectively. Additionally or alternatively the transmitter station may be different from the sample container carrier. Furthermore, the transmitter station may be an electric transmitter station and/or a wireless transmitter station, in particular a radio transmitter station, in particular comprising an antenna, in particular a RDIF transmitter station and/or a NFC transmitter station. The transmitter station may be denoted as writer station. Information may be such as described above in the context of the memory element.

According to an embodiment of the invention the laboratory system comprises a barcode reader and assignment station. The barcode reader and assignment station is adapted to read, in particular to automatically read, a barcode of the laboratory sample container and to logically assign, in particular to automatically assign, the read barcode to the sample container. In particular the barcode reader and assignment station may be adapted to transmit the read barcode to the sample container carrier. Additionally or alternatively the barcode reader and assignment station may be different from the sample container carrier. Furthermore, the barcode reader and assignment station may be an electric barcode reader and assignment station, in particular the barcode reader and assignment station may comprise a camera.

According to an embodiment of the invention the laboratory system comprises a loading and assignment station. The loading and assignment station is adapted to load, in particular automatically load, the laboratory sample container on the sample container carrier and to determine, in particular to automatically determine, that the logic assignment of the sample container carrier to the loaded laboratory sample container is valid. In particular the loading and assignment station may be adapted to transmit information, that the logic assignment of the sample container carrier to the loaded laboratory sample container is valid, to the sample container carrier. Additionally or alternatively the loading and assignment station may be different from the sample container carrier. Furthermore, the loading and assignment station may be an electric loading and assignment station. Moreover, the loading and assignment station may be denoted as inserting and assignment station.

The invention further relates to a laboratory sample distribution system for a laboratory automation system. The laboratory sample distribution system comprises a laboratory system as described above and a transport plane, a number of drive elements (e.g. 1 to 10000) and a, in particular the, control device. The transport plane is adapted to support the sample container carrier, in particular with the carried laboratory sample container. The number of drive elements is adapted to move, in particular to automatically move, the sample container carrier, in particular with the carried laboratory sample container, on the transport plane. The control device is configured to control, in particular to automatically control, the number of drive elements, such that the sample container carrier moves on the transport plane along a corresponding, in particular individual, transport path.

By means of the laboratory system according to the invention, the advantages of the laboratory system according to the invention, as discussed above, may be made applicable for the laboratory sample distribution system.

In particular the transport plane may be denoted as transport surface. To support the sample container carrier be denoted to carry the sample container carrier. The sample container carrier may be translationally moved on or over the transport plane. Furthermore, the sample container carrier may be adapted to move in two dimensions on the transport plane. Moreover, the sample container carrier may slide over the transport plane. In particular the laboratory sample distribution system may comprise a plurality of sample container carriers (e.g. 1 to 1000), in particular as described above. The number of drive elements may be a number of electric drive elements. The control device may be configured to control the number of drive elements, such that the plurality of sample container carriers moves on the transport plane along corresponding, in particular individual, transport paths simultaneously. Further, the control device may comprise or be an integrated circuit, a tablet computer, a smartphone or a computer.

Furthermore, the receiver station, the transmitter station, the barcode reader and assignment station and/or the loading and assignment station, if present, may be arranged adjacent or directly next to the laboratory sample distribution system, in particular to the transport plane of the laboratory sample distribution system.

According to an embodiment of the invention the sample container carrier comprises a magnetically active device. The number of drive elements comprises a number of electro-magnetic actuators. The number of electro-magnetic actuators is stationary arranged below the transport plane and is adapted to move, in particular to automatically move, the sample container carrier on the transport plane by applying a magnetic drive force to the sample container carrier. The control device is configured to control, in particular to automatically control, the number of electro-magnetic actuators, such that the sample container carrier moves on the transport plane along the corresponding transport path.

In particular the number of electro-magnetic actuators may be adapted to generate a magnetic field to move the sample container carrier on the transport plane. The magnetically active device may be adapted to interact with the magnetic field generated by the number of electro-magnetic actuators, such that the magnetic drive force is applied to the sample container carrier. In particular the magnetically active device may be a permanent magnet or an electromagnet. Additionally or alternatively the magnetically active device may comprise a magnetically soft material. The number of electro-magnetic actuators may be a number of solenoids surrounding ferromagnetic cores. Furthermore, the number of electro-magnetic actuators may be driven or energized individually in order to generate or to provide the magnetic field. Moreover, the electro-magnetic actuators may be arranged in two dimensions, in particular in a grid having rows and columns, along which the electro-magnetic actuators are arranged. Further, the electro-magnetic actuators may be arranged in a plane parallel to the transport plane.

Additionally or alternatively the number of drive elements may comprise at least one wheel and a drive motor to drive the wheel. The drive motor and the wheel may be adapted to move, in particular to automatically move, the sample container carrier on the transport plane. The control device may be configured to control, in particular to automatically control, the at least one wheel and/or the drive motor, such that the sample container carrier moves on the transport plane along the corresponding transport path. In particular the sample container carrier may comprise the at least one wheel and/or the at least one drive motor.

The invention further relates to a laboratory automation system. The laboratory automation system comprises a number of analytical stations. The number of analytical stations is adapted to analyze, in particular to automatically analyze, a sample. Furthermore, the laboratory automation system comprises a laboratory system as described above and/or a laboratory sample distribution system as described above. The laboratory sample distribution system, if present, is adapted to move, in particular to automatically move, the sample container carrier to the number of analytical stations. The laboratory automation system or its control device, if present, is adapted to prevent, in particular to automatically prevent, analyzing and/or logically assigning an analytical result to the sample contained by the carried laboratory sample container based on the determined invalid logic assignment, in particular of the sample container carrier to the laboratory sample container.

By means of the laboratory system and/or the laboratory sample distribution system according to the invention, the advantages of the laboratory system and/or the laboratory sample distribution system according to the invention, as discussed above, may be made applicable for the laboratory automation system.

In other words: the laboratory automation system or its control device, if present, may be adapted to reject, in particular to automatically reject, the sample container carrier, the carried laboratory sample container and/or the sample contained by the laboratory sample container based on the determined invalid logic assignment. Additionally or alternatively, the laboratory automation system or its control device, if present, may be adapted to allow, in particular to automatically allow, analyzing and/or logically assigning the analytical result to the sample contained by the carried laboratory sample container based on the, in particular determined, valid logic assignment, in particular of the sample container carrier to the laboratory sample container.

The number of analytical stations may be different from the sample container carrier. In particular the number of analytical stations may be adapted to use the sample or a part of the sample and a reagent to generate a measuring signal, the measuring signal indicating if and in which concentration, if any, an analyte is existing.

Furthermore, the laboratory automation system may comprise a number of pre-analytical stations and/or post-analytical stations. The number of pre-analytical stations may be adapted to perform any kind of pre-processing of the sample, the laboratory sample container and/or the sample container carrier. The number of post-analytical stations may be adapted to perform any kind of post-processing of the sample, the laboratory sample container and/or the sample container carrier.

The number of pre-analytical, analytical and/or post-analytical stations may comprise at least one of a decapping station, a recapping station, an aliquot station, a centrifugation station, an archiving station, a pipetting station, a sorting station, a tube type identification station, a sample quality determining station, an add-on buffer station, a liquid level detection station, a sealing/desealing station, a pushing station, a belt station, a conveying system station and/or a gripper station for moving the laboratory sample container to or from the sample container carrier.

Moreover, the number of analytical, pre-analytical and/or post-analytical stations, if present, may be arranged adjacent or directly next to the laboratory sample distribution system, if present, in particular to the transport plane of the laboratory sample distribution system.

In particular the laboratory sample distribution system, if present, may be adapted to move the sample container carrier to the number of pre-analytical stations, post-analytical stations, the receiver station, the transmitter station, the barcode reader and assignment station and/or the loading and assignment station, if present. In particular the laboratory sample distribution system may be adapted to move the sample container carrier in between the stations.

### BRIEF DESCRIPTION OF THE DRAWINGS

In the following, an embodiment of the invention will be described in detail with reference to the drawings. Throughout the drawings, the same elements will be denoted by the same reference numerals.
- Fig. 1: shows a perspective view of a sample container carrier of a laboratory system according to the invention of a laboratory sample distribution system according to the invention of a laboratory automation system according to the invention,
- Fig. 2: shows a schematic diagram of the sample container carrier of Fig. 1 comprising a memory element in form of a capacitor,
- Fig. 3: shows another schematic diagram of the sample container carrier of Fig. 1 comprising a memory element in form of a capacitor,
- Fig. 4: shows another schematic diagram of the sample container carrier of Fig. 1 comprising a memory element in form of a flip-flop,
- Fig. 5: shows another schematic diagram of the sample container carrier of Fig. 1 comprising a memory element in form of a microcontroller,
- Fig. 6: shows another schematic diagram of the sample container carrier of Fig. 1 comprising a memory element in form of a flip-flop,
- Fig. 7: shows another schematic diagram of the sample container carrier of Fig. 1 comprising a memory element in form of a microcontroller,
- Fig. 8: shows a side view of a loading and assignment station, a barcode reader and assignment station and a transmitter station of the laboratory system according to the invention,
- Fig. 9: shows a removal of a laboratory sample container from the sample container carrier of Fig. 1,
- Fig. 10: shows a side view of a receiver station of the laboratory system according to the invention and an analytical station of the laboratory automation system according to the invention,
- Fig. 11: shows a perspective view of the laboratory sample distribution system according to the invention, and
- Fig. 12: shows a side view of the sample container carrier of Fig. 1.

### DETAILED DESCRIPTION OF EMBODIMENTS OF THE INVENTION

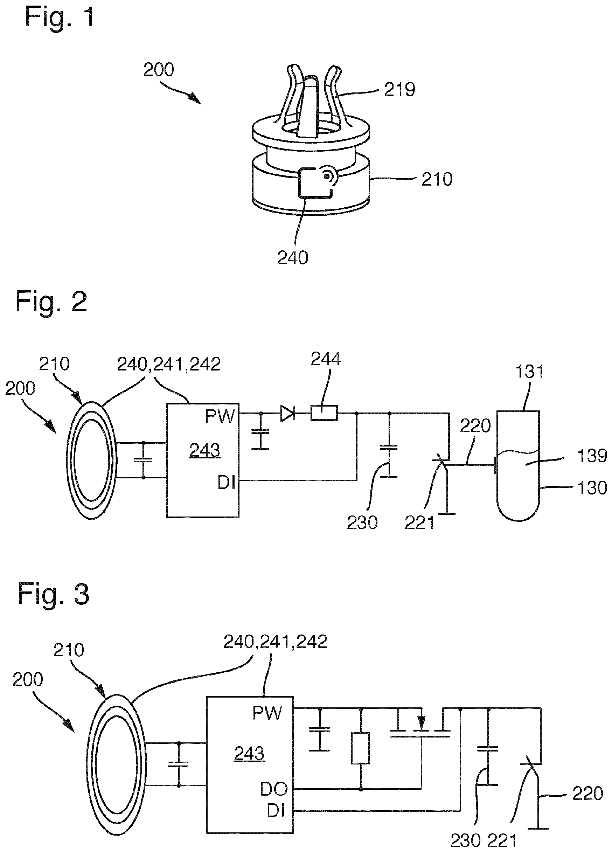

Fig. 1 to 12 show an inventive laboratory automation system 10. The laboratory automation system 10 comprises an inventive laboratory sample distribution system 100. The laboratory sample distribution system 100 comprises an inventive laboratory system 200.

The laboratory system 200 comprises a sample container carrier 210. The sample container carrier 210 is adapted to carry a laboratory sample container 130 and comprises a removal detector 220. The removal detector 220 is adapted to interact with the laboratory sample container 130 to detect a removal of the carried laboratory sample container 130 from the sample container carrier 210. Furthermore, the laboratory system 200 is adapted to determine based on the detected removal, that a before valid logic assignment of the sample container carrier 210 to the carried laboratory sample container 130 is invalid.

In the shown embodiment the laboratory sample container 130 is designed as a tube and has an opening 131 at an, in particular upper, end, as shown in Fig. 2 and 8 to 12. Furthermore, the laboratory sample container 130 contains a sample 139 in form of a liquid.

In detail the sample container carrier 210 comprises at least one holding element 219, as shown in Fig. 1, 8 to 10 and 12. The at least one holding element 219 is adapted to hold the laboratory sample container 130, in particular at a circumference of the laboratory sample container 130.

Moreover, the sample container carrier 130 comprises a holding region, in particular defined by the at least one holding element 219, for the laboratory sample container 130.

The removal detector 220 is arranged in a bottom of the sample container carrier 210, in particular at an, in particular lower, end of the holding region.

In the shown embodiment the removal detector 220 is adapted to interact with the laboratory sample container 130 by contact, in particular by contacting the laboratory sample container 130 at its circumference. In detail the removal detector 220 comprises a switch 221, in particular a mechanical switch, as shown in Fig. 2 to 7. The switch 221 is adapted to be depressed by the laboratory sample container 130, if present, and not depressed, if the laboratory sample container 130 is absent, in particular by a spring.

In alternative embodiments the removal detector may be adapted to interact with the laboratory sample container contactless. Additionally or alternatively in alternative embodiments the removal detector may comprise an optical sensor, a capacitive sensor, a pressure sensor, a temperature sensor, and/or a shape memory alloy being adapted to interact with the laboratory sample container to detect a removal of the carried laboratory sample container from the sample container carrier.

Further, the sample container carrier 210 comprises a memory element 230. In the shown embodiment the memory element 230 is adapted to store information based on, that the logic assignment is valid, and information based on, that the logic assignment is invalid. In alternative embodiments the memory element may be adapted to store information based on the detected removal, in particular a time of or a time period since the detected removal.

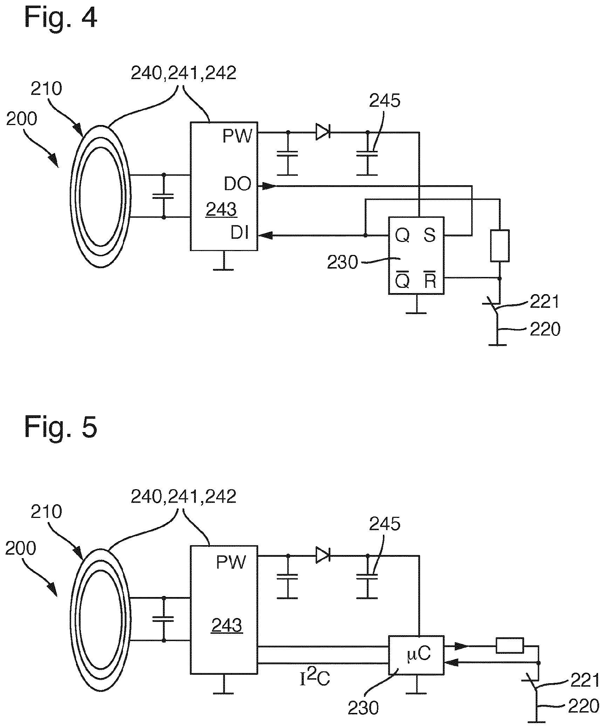

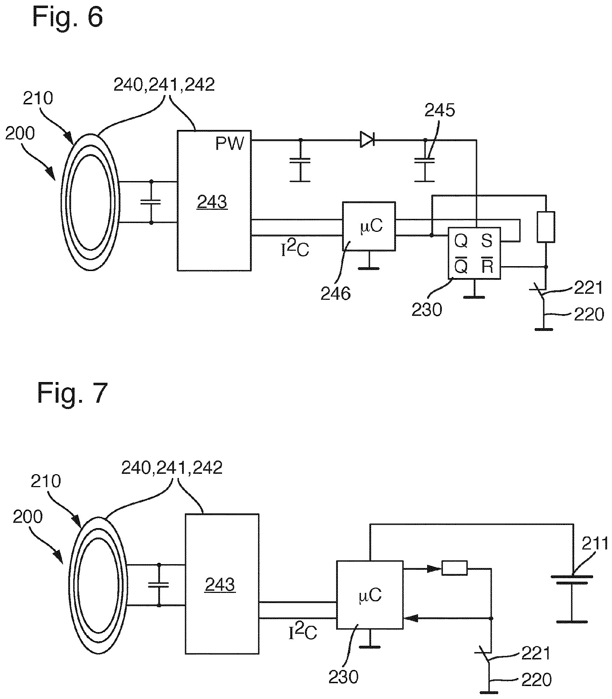

In detail the memory element 230 comprises a capacitor in Fig. 2 and 3, a flip-flop in Fig. 4 and 6, a microcontroller in Fig. 5 and 7. In particular the memory element has two states. A first state is, that the logic assignment is valid, and a second state is, that the logic assignment is invalid.

Furthermore, the sample container carrier 210 comprises a transponder 240, in particular a RFID, NFC transponder, in particular comprising an antenna. The transponder 240 comprises a receiver 241 and a transmitter 242.

The receiver 241 is adapted to receive information based on, that the logic assignment is valid and to store the information on the memory element 230. This may be denoted to arm the sample container carrier 210 or its memory element 230, respectively.

In the shown embodiment the transmitter 242 is adapted to transmit information based on, that the logic assignment is valid. In alternative embodiments the transmitter may be adapted to transmit information based on the detected removal and/or information, that the logic assignment is invalid.

In detail the removal detector 220 is adapted to delete information based on, that the logic assignment is valid, in particular from the memory element 230, based on the detected removal. In other words: the removal detector 220 is adapted to store information based on, that the logic assignment is invalid, in particular on the memory element 230. If the valid information is deleted or the information is, that the logic assignment is invalid, respectively, the transmitter 242 does not transmit.

In particular the transponder 240 is adapted to receive an interrogation for the information, in particular by its receiver 241, and to transmit the information, in particular that the logic assignment is valid, in response to the received interrogation, in particular by its transmitter 242.

Moreover, in Fig. 2 to 6 the receiver 241 is adapted to collect energy, in particular from the received information and/or from the interrogation, and to supply the sample container carrier 210, in particular its memory element 230, with the collected energy.

In Fig. 7 the sample container carrier 210 comprises an own power source 211, in particular a battery.

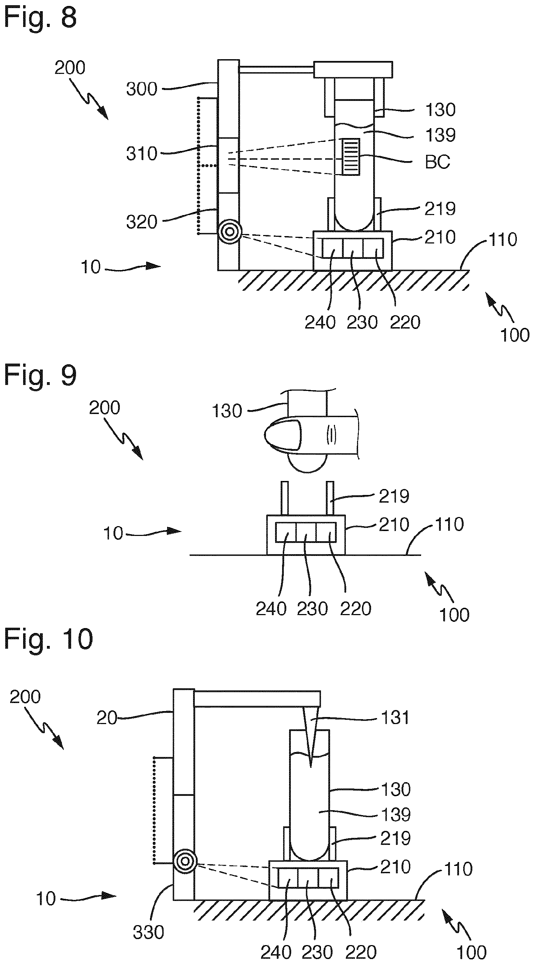

Further, the laboratory system 200 comprises a loading and assignment station 300, in particular comprising a gripper, as shown in Fig. 8. The loading and assignment station 300 is adapted to load the laboratory sample container 130 on the sample container carrier 210 and to determine, that the logic assignment of the sample container carrier 210 to the loaded laboratory sample container 300 is valid.

Furthermore, the laboratory system 200 comprises a barcode reader and assignment station 310, in particular comprising a camera. The barcode reader and assignment station 310 is adapted to read a barcode BC of the laboratory sample container 130 and to logically assign the read barcode BC to the sample container 210.

Moreover, the laboratory system comprises a transmitter station 320, in particular a RFID, NFC transmitter station, in particular comprising an antenna. The transmitter station 320 is adapted to transmit information, that the logic assignment is valid, to the sample container carrier 210.

This may be denoted to arm the sample container carrier 210 or its memory element 230, respectively. In particular the transmitter station 320 is adapted to transmit energy, in particular with the information, to the sample container carrier 210.

In the shown embodiment the transmitter station 320 transmits the read barcode BC of the laboratory sample container 130 to the sample container 210. Thereby, information, that the logic assignment of the sample container carrier 210 to the loaded laboratory sample container 130 is valid, is transmitted to the sample container carrier 210. In particular the loading and assignment station 300, the barcode reader and assignment station 310 and the transmitter station 320 are functionally coupled, in particular in signal connection with each other, as shown in Fig. 8 by a dotted line.

In detail the sample container carrier 210 or its transponder 240, respectively, comprises a control circuit 243. The received barcode BC is stored by the control circuit 243.

Further, the memory element 230 comprising the capacitor in Fig. 2 is charged by power harvesting, in particular via an power harvesting output PW of the transponder 240 or its control circuit 243, respectively. When the laboratory sample container 130 is removed, as shown in Fig. 9, the capacitor 230 is uncharged. The memory state can be read out by the transponder 240 or its control circuit 243, respectively, in particular via an digital input DI of the control circuit 243, with the next interrogation. Furthermore, the sample container carrier 210 comprises a time-delay-resistor 244, in particular in order to avoid a too fast recharge of the capacitor 230, in particular during the next interrogation. If the memory state is the second state, that the logic assignment is invalid, the stored barcode BC is deleted by the control circuit 243 and no response is transmitted. If the memory state is the first state, that the logic assignment is valid, the stored barcode BC is transmitted.

The memory element 230 comprising the capacitor in Fig. 3 is charged by power harvesting, in particular triggered by an digital output DO of the control circuit 243. When the laboratory sample container 130 is removed, the capacitor 230 is uncharged. The memory state can be read out by the transponder 240 or its control circuit 243, respectively, with the next interrogation, wherein a recharge of the capacitor 230 can be avoided by not triggering the digital output DO.

The memory element 230 comprising the flip-flop, in particular a RS flip-flop, in Fig. 4 is buffered by a capacitor 245 charged by power harvesting. The flip-flop 230 is set by the digital output DO. When the laboratory sample container 130 is removed, the flip-flop 230 is reset. The memory state can be read out by the transponder 240 or its control circuit 243, respectively, with the next interrogation, wherein a setting of the flip-flop 230 can be avoided by not triggering the digital output DO.

The memory element 230 comprising the microcontroller in Fig. 5 is buffered by the capacitor 245 charged by power harvesting. The microcontroller 230 checks the removal detector 220 or a status of the removal detector 220, respectively, and stores it. The memory state can be read out by the transponder 240 or its control circuit 243, respectively, with the next interrogation, in particular by a bus connection in between the control circuit 243 and the microcontroller 230.

The memory element 230 comprising the flip-flop, in particular a RS flip-flop, in Fig. 6 is buffered by the capacitor 245 charged by power harvesting. The flip-flop 230 is set by the digital output DO. When the laboratory sample container 130 is removed, the flip-flop 230 is reset. A microcontroller 246 is supplied by power harvesting, in particular with the collected energy. The memory state can be read out by the transponder 240 or its control circuit 243, respectively, with the next interrogation, in particular by a bus connection in between the control circuit 243 and the flip-flop 230 via the microcontroller 246. In other words: the microcontroller 246 is adapted, in particular only adapted, for communication between the control circuit 243 and the flip-flop 230.

The memory element 230 comprising the microcontroller in Fig. 7 is powered by the power source 211. The microcontroller 230 checks the removal detector 220 or a status of the removal detector 220, respectively, and stores it, in particular by a signal from a digital output to a digital input. When the laboratory sample container 130 is removed, the digital input detects this. The digital output may be set to low, what in particular may save energy. The memory state can be read out by the transponder 240 or its control circuit 243, respectively, with the next interrogation, in particular by a bus connection in between the control circuit 243 and the microcontroller 230.

In other words: the sample container carrier 210 is adapted to determine based on the detected removal, that the before valid logic assignment of the sample container carrier 210 to the carried laboratory sample container 130 is invalid.

Further, the laboratory system 200 comprises a receiver station 330, in particular a RFID, NFC receiver station, in particular comprising an antenna, as shown in Fig. 10. In the shown embodiment the receiver station 330 is adapted to receive information based on, that the logic assignment is valid, in particular the barcode BC of the laboratory sample container 130, from the sample container carrier 210. In alternative embodiments the receiver station may be adapted to receive information based on the detected removal and/or information, that the logic assignment is invalid.

In detail the receiver station 330 is adapted to transmit the interrogation and the sample container carrier 210 responds, if the logic assignment is still valid. If the valid information is deleted, the sample container carrier 210 does not respond and the receiver station 330 does not receive information. This enables the receiver station 330 to recognize, that the logic assignment is invalid. In particular the receiver station 330 is adapted to transmit energy, in particular with the interrogation, to the sample container carrier 210.

Furthermore, the laboratory automation system 10 comprises a number of analytical stations 20. The number of analytical stations 20 is adapted to analyze the sample 139. The laboratory automation system 200 is adapted to prevent analyzing, in particular by the number of analytical stations 20, and/or logically assigning an analytical result to the sample 139 contained by the carried laboratory sample container 130 based on the determined invalid logic assignment. In particular the sample container carrier 210 is rejected based on the determined invalid logic assignment.

Additionally, the laboratory automation system 10 is adapted to allow analyzing and/or logically assigning the analytical result to the sample 139 contained by the carried laboratory sample container 130 based on the valid logic assignment.

In particular the receiver station 330 and the number of analytical stations 20 are functionally coupled, in particular in signal connection with each other, as shown in Fig. 10 by a dotted line.

The logic assignment, in particular the from the sample container carrier 210 transmitted and from the receiver station 330 received valid logic assignment in form of the barcode BC, allows or makes it possible to control and track the laboratory sample container 130 or the sample 139 contained by the laboratory sample container 139, respectively, over a workflow or a processing path, respectively.

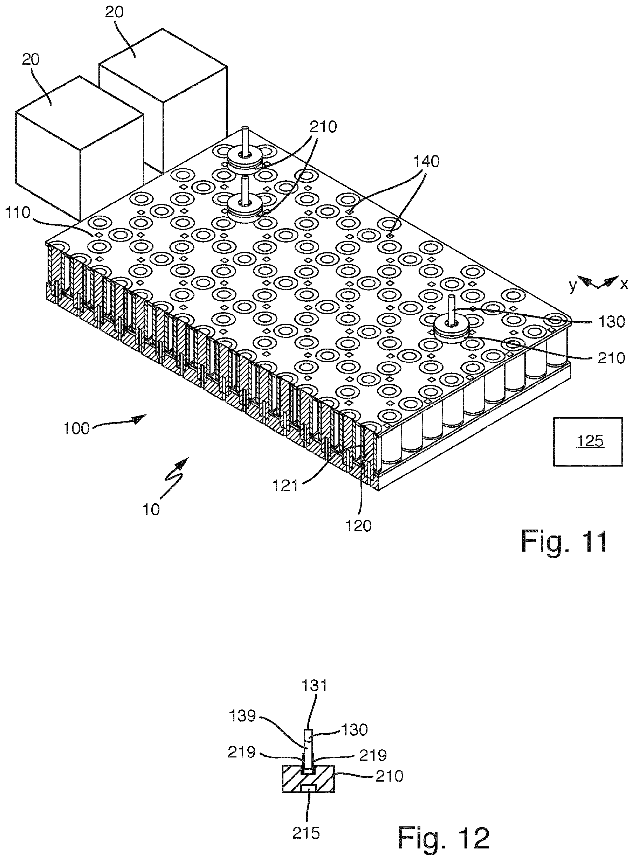

Self-evidently, more than the two analytical stations 20 shown in Fig. 11 may be comprised in the laboratory automation system 10.

The laboratory sample container 130 or its opening 131, respectively, is open for processing, in particular analyzing, the sample 139 contained by the laboratory sample container 130.

Moreover, the sample container carrier 210 is adapted to move the carried, in particular open, laboratory sample container 130 in the laboratory sample distribution system 100, as shown in Fig. 8 to 11, and/or in the laboratory automation system 10.

The laboratory sample distribution system 100 comprises a transport plane 110, a number of drive elements 120 and a control device 125. The transport plane 110 is adapted to support the sample container carrier 210. The number of drive elements 120 is adapted to move the sample container carrier 210 on the transport plane 110. The control device 125 is configured to control the number of drive elements 120, such that the sample container carrier 210 moves on the transport plane 110 along a corresponding transport path.

Further, the laboratory automation system 10 comprises a number of pre-analytical stations and/or post-analytical stations.

The loading and assignment station 300, the barcode reader and assignment station 310, the transmitter station 320, the receiver station 330, the number of analytical stations 20, the number of pre-analytical stations and the number of post-analytical stations are arranged adjacent to the laboratory sample distribution system 100, in particular to the transport plane 110.

Furthermore, the laboratory sample distribution system 100 is adapted to move the sample container carrier 210 to the loading and assignment station 300, the barcode reader and assignment station 310, the transmitter station 320, the receiver station 330, the number of analytical stations 20, the number of pre-analytical stations and the number of post-analytical stations.

Moreover, the control device 125 is configured to control the loading and assignment station 300, the barcode reader and assignment station 310, the transmitter station 320, the receiver station 330, the number of analytical stations 20, the number of pre-analytical stations and the number of post-analytical stations.

In detail the sample container carrier 210 can be translationally moved in two dimensions x, y being perpendicular to each other on the transport plane 110. In the shown embodiment a sliding surface of the sample container carrier 210 is adapted to be in contact with the transport plane 110 and enables performing movements, in particular slides, of the sample container carrier 210 on the transport plane 110. In particular the laboratory sample distribution system 100 comprises a plurality of sample container carriers 110. Self-evidently, more than the three sample container carriers 210 shown in Fig. 11 may be comprised in the laboratory sample distribution system 100. The control device 125 is configured to control the number of drive elements 120, such that the plurality of sample container carriers 210 moves on the transport plane 110 along corresponding, in particular individual, transport paths, simultaneously.

In the shown embodiment the sample container carrier 210 comprises a magnetically active device 215, in particular in form of a permanent magnet, as shown in Fig. 12. The number of drive elements 120 comprises a number of electro-magnetic actuators 121. The number of electro-magnetic actuators 121 is stationary arranged below the transport plane 110 and is adapted to move the sample container carrier 210 on the transport plane 110 by applying a magnetic drive force to the sample container carrier 210. The control device 125 is configured to control the number of electro-magnetic actuators 121, such that the sample container carrier 210 moves on the transport plane 110 along the corresponding transport path.

In detail the number of electro-magnetic actuators 121 is adapted to generate a magnetic field to move the sample container carrier 210 on the transport plane 110. The magnetically active device 215 is adapted to interact with the magnetic field generated by the number of electro-magnetic actuators 121, such that the magnetic drive force is applied to the sample container carrier 210. Furthermore, the number of electro-magnetic actuators 121 can be driven individually in order to generate the magnetic field. In particular the number of electro-magnetic actuators 121 is implemented as solenoids having a solid ferromagnetic core. Moreover, the electro-magnetic actuators 121 are quadratically arranged in a grid having rows and columns, in particular in a plane parallel to the transport plane 110. In each center of a quadrat formed by corresponding electro-magnetic actuators 121 no electro-magnetic actuator is arranged. In other words: in each second row in each second position there is no electro-magnetic actuator 121.

Further, the laboratory sample distribution system 100 comprises a number of Hall-sensors 140. The number of Hall-sensors 140 is arranged, such that a position of a respective sample container carrier 210 on the transport plane 110 can be detected. The control device 125 is functionally coupled to, in particular in signal connection with, the Hall-sensors 140 for detecting the position of the sample container carrier 210. The control device 125 is adapted to control the electro-magnetic actuators 121 in response to the detected position.

As the shown and above discussed embodiments reveal, the invention provides a laboratory system, which enables to ensure integrity of a logic assignment of an analytical result to a sample. Furthermore, the invention provides a laboratory sample distribution system comprising such a laboratory system and a laboratory automation system comprising such a laboratory system and/or such a laboratory sample distribution system.

## Claims

1. Laboratory system (200) for a laboratory automation system (10),
- wherein the laboratory system (200) comprises a sample container carrier (210), wherein the sample container carrier (210) is adapted to carry a laboratory sample container (130) and comprises a removal detector (220), wherein the removal detector (220) is adapted to interact with the laboratory sample container (130) to detect a removal of the carried laboratory sample container (130) from the sample container carrier (210), and
- wherein the laboratory system (200) is adapted to determine based on the detected removal, that a before valid logic assignment of the sample container carrier (210) to the carried laboratory sample container (130) is invalid,
**characterized in**
- **that** the sample container carrier (210) comprises a memory element (230), wherein the memory element (230) is adapted to store information based on the detected removal, information based on, that the logic assignment is valid, and/or information based on, that the logic assignment is invalid,
- **that** the sample container carrier (210) comprises a receiver (241), wherein the receiver (241) is adapted to receive information based on, that the logic assignment is valid, and to store the information on the memory element (230),
- **that** the sample container carrier (200) comprises a transmitter (242), wherein the transmitter (242) is adapted to transmit information based on the detected removal, information based on, that the logic assignment is valid, and/or information, that the logic assignment is invalid,
- **that** the sample container carrier (210) comprises a transponder (240), wherein the transponder (240) comprises the transmitter (242) and the receiver (241) and wherein the transponder (240) is adapted to receive an interrogation for the information and to transmit the information in response to the received interrogation,
- **that** the transponder (240) is a near-field communication transponder, and
- **that** the receiver (241) is adapted to collect energy and to supply the sample container carrier (210) with the collected energy.

2. Laboratory system (200) according to claim 1, wherein the removal detector (220) comprises:
- a switch (221), an optical sensor, a capacitive sensor, a pressure sensor, a temperature sensor, and/or a shape memory alloy being adapted to interact with the laboratory sample container (130) to detect a removal of the carried laboratory sample container (130) from the sample container carrier (210).

3. Laboratory system (200) according to any one of the preceding claims, comprising:
- a receiver station (330), wherein the receiver station (330) is adapted to receive information based on the detected removal, information based on, that the logic assignment is valid, and/or information, that the logic assignment is invalid, from the sample container carrier (210).

4. Laboratory system (200) according to any one of the preceding claims, comprising:
- a transmitter station (320), wherein the transmitter station (320) is adapted to transmit information, that the logic assignment is valid, to the sample container carrier (210).

5. Laboratory system (200) according to any one of the preceding claims, comprising:
- a barcode reader and assignment station (310), wherein the barcode reader and assignment station (310) is adapted to read a barcode (BC) of the laboratory sample container (130) and to logically assign the read barcode (BC) to the sample container (210).

6. Laboratory system (200) according to any one of the preceding claims, comprising:
- a loading and assignment station (300), wherein the loading and assignment station (300) is adapted to load the laboratory sample container (130) on the sample container carrier (210) and to determine, that the logic assignment of the sample container carrier (210) to the loaded laboratory sample container (130) is valid.

7. Laboratory sample distribution (100) system for a laboratory automation system (10), comprising:
- a laboratory system (200) according to any one of the preceding claims,
- a transport plane (110), wherein the transport plane (110) is adapted to support the sample container carrier (210),
- a number of drive elements (120), wherein the number of drive elements (120) is adapted to move the sample container carrier (210) on the transport plane (110), and
- a control device (125), wherein the control device is configured to control the number of drive elements (120), such that the sample container carrier (210) moves on the transport plane (110) along a corresponding transport path.

8. Laboratory sample distribution (100) system according to claim 7,
- wherein the sample container carrier (210) comprises a magnetically active device (215),
- wherein the number of drive elements (120) comprises a number of electro-magnetic actuators (121), wherein the number of electro-magnetic actuators (121) is stationary arranged below the transport plane (110) and is adapted to move the sample container carrier (210) on the transport plane (110) by applying a magnetic drive force to the sample container carrier (210), and
- wherein the control device (125) is configured to control the number of electro-magnetic actuators (121), such that the sample container carrier (210) moves on the transport plane (110) along the corresponding transport path.

9. Laboratory automation system (10), comprising:
- a number of analytical stations (20), wherein the number of analytical stations (20) is adapted to analyze a sample (139),
- a laboratory system (200) according to any one of claims 1 to 6 and/or a laboratory sample distribution system (100) according to claim 7 or 8, wherein the laboratory sample distribution system (100) is adapted to move the sample container carrier (210) to the number of analytical stations (20),
- wherein the laboratory automation system (10) is adapted to prevent analyzing and/or logically assigning an analytical result to the sample (139) contained by the carried laboratory sample container (130) based on the determined invalid logic assignment.

## Patentansprüche

1. Laborsystem (200) für ein Laborautomatisierungssystem (10),
- wobei das Laborsystem (200) einen Probenbehälterträger (210) umfasst, wobei der Probenbehälterträger (210) dafür ausgelegt ist, einen Laborprobenbehälter (130) zu tragen und einen Entnahmemelder (220) umfasst, wobei der Entnahmemelder (220) dafür ausgelegt ist, mit dem Laborprobenbehälter (130) zu interagieren, um eine Entnahme des getragenen Laborprobenbehälters (130) aus dem Probenbehälterträger (210) zu melden, und
- wobei das Laborsystem (200) dafür ausgelegt ist, basierend auf der gemeldeten Entnahme zu bestimmen, dass eine zuvor gültige logische Zuordnung des Probenbehälterträgers (210) zu dem getragenen Laborprobenbehälter (130) ungültig ist, **dadurch gekennzeichnet,**
- **dass** der Probenbehälterträger (210) ein Speicherelement (230) umfasst, wobei das Speicherelement (230) dafür ausgelegt ist, Informationen, die auf der gemeldeten Entnahme basieren, Informationen, die darauf basieren, dass die logische Zuordnung gültig ist, und/oder Informationen, die darauf basieren, dass die logische Zuordnung ungültig ist, zu speichern,
- **dass** der Probenbehälterträger (210) einen Empfänger (241) umfasst, wobei der Empfänger (241) dafür ausgelegt ist, Informationen zu empfangen, die darauf basieren, dass die logische Zuordnung gültig ist, und die Informationen auf dem Speicherelement (230) zu speichern,
- **dass** der Probenbehälterträger (200) einen Sender (242) umfasst, wobei der Sender (242) dafür ausgelegt ist, Informationen, die auf der gemeldeten Entnahme basieren, Informationen, die darauf basieren, dass die logische Zuordnung gültig ist, und/oder Informationen, dass die logische Zuordnung ungültig ist, zu senden,
- **dass** der Probenbehälterträger (210) einen Transponder (240) umfasst, wobei der Transponder (240) den Sender (242) und den Empfänger (241) umfasst und wobei der Transponder (240) dafür ausgelegt ist, eine Abfrage für die Informationen zu empfangen und die Informationen als Reaktion auf die empfangene Abfrage zu senden,
- **dass** der Transponder (240) ein Nahfeldkommunikationstransponder ist, und
- **dass** der Empfänger (241) dafür ausgelegt ist, Energie zu sammeln und den Probenbehälterträger (210) mit der gesammelten Energie zu versorgen.

2. Laborsystem (200) nach Anspruch 1, wobei der Entnahmemelder (220) Folgendes umfasst:
- einen Schalter (221), einen optischen Sensor, einen kapazitiven Sensor, einen Drucksensor, einen Temperatursensor und/oder eine Formgedächtnislegierung, die dafür ausgelegt ist, mit dem Laborprobenbehälter (130) zu interagieren, um eine Entnahme des getragenen Laborprobenbehälters (130) aus dem Probenbehälterträger (210) zu melden.

3. Laborsystem (200) nach einem der vorstehenden Ansprüche, umfassend:
- eine Empfängerstation (330), wobei die Empfängerstation (330) dafür ausgelegt ist, Informationen, die auf der gemeldeten Entnahme basieren, Informationen, die darauf basieren, dass die logische Zuordnung gültig ist, und/oder Informationen, dass die logische Zuordnung ungültig ist, von dem Probenbehälterträger (210) zu empfangen.

4. Laborsystem (200) nach einem der vorstehenden Ansprüche, umfassend:
- eine Senderstation (320), wobei die Senderstation (320) dafür ausgelegt ist, Informationen, dass die logische Zuordnung gültig ist, an den Probenbehälterträger (210) zu senden.

5. Laborsystem (200) nach einem der vorstehenden Ansprüche, umfassend:
- ein Barcode-Lesegerät und eine Zuordnungsstation (310), wobei das Barcode-Lesegerät und die Zuordnungsstation (310) dafür ausgelegt sind, einen Barcode (BC) des Laborprobenbehälters (130) zu lesen und den gelesenen Barcode (BC) dem Probenbehälter (210) logisch zuzuordnen.

6. Laborsystem (200) nach einem der vorstehenden Ansprüche, umfassend:
- eine Lade- und Zuordnungsstation (300), wobei die Lade- und Zuordnungsstation (300) dafür ausgelegt ist, den Laborprobenbehälter (130) auf den Probenbehälterträger (210) zu laden und zu bestimmen, dass die logische Zuordnung des Probenbehälterträgers (210) zu dem geladenen Laborprobenbehälter (130) gültig ist.

7. Laborprobenverteilungssystem (100) für ein Laborautomatisierungssystem (10), umfassend:
- ein Laborsystem (200) nach einem der vorstehenden Ansprüche,
- eine Transportebene (110), wobei die Transportebene (110) dafür ausgelegt ist, den Probenbehälterträger (210) zu halten,
- mehrere Antriebselemente (120), wobei die mehreren Antriebselemente (120) dafür ausgelegt sind, den Probenbehälterträger (210) auf der Transportebene (110) zu bewegen, und
- eine Steuerungsvorrichtung (125), wobei die Steuerungsvorrichtung dafür ausgebildet ist, die mehreren Antriebselemente (120) so zu steuern, dass sich der Probenbehälterträger (210) auf der Transportebene (110) entlang eines entsprechenden Transportweges bewegt.

8. Laborprobenverteilungssystem (100) nach Anspruch 7,
- wobei der Probenbehälterträger (210) eine magnetisch wirksame Vorrichtung (215) umfasst,
- wobei die mehreren Antriebselemente (120) mehrere elektromagnetische Aktuatoren (121) umfassen, wobei die mehreren elektromagnetischen Aktuatoren (121) stationär unter der Transportebene (110) angeordnet und dafür ausgelegt sind, den Probenbehälterträger (210) auf der Transportebene (110) zu bewegen, indem eine magnetische Antriebskraft auf den Probenbehälterträger (210) ausgeübt wird, und
- wobei die Steuerungsvorrichtung (125) dafür ausgebildet ist, die mehreren elektromagnetischen Aktuatoren (121) so zu steuern, dass sich der Probenbehälterträger (210) auf der Transportebene (110) entlang eines entsprechenden Transportweges bewegt.

9. Laborautomatisierungssystem (10), umfassend:
- mehrere Analysestationen (20), wobei die mehreren Analysestationen (20) dafür ausgelegt sind, eine Probe (139) zu analysieren,
- ein Laborsystem (200) nach einem der Ansprüche 1 bis 6 und/oder ein Laborprobenverteilungssystem (100) nach Anspruch 7 oder 8, wobei das Laborprobenverteilungssystem (100) dafür ausgelegt ist, den Probenbehälterträger (210) zu den mehreren Analysestationen (20) zu bewegen,
- wobei das Laborautomatisierungssystem (10) dafür ausgelegt ist, das Analysieren und/oder logische Zuordnen eines Analyseergebnisses der Probe (139), die in dem getragenen Laborprobenbehälter (130) enthalten ist, basierend auf der bestimmten ungültigen logischen Zuordnung zu verhindern.

## Revendications

1. Système de laboratoire (200) pour un système d'automatisation de laboratoire (10),
- dans lequel le système de laboratoire (200) comprend un support de récipient d'échantillon (210), dans lequel le support de récipient d'échantillon (210) est adapté pour transporter un récipient d'échantillon de laboratoire (130) et comprend un détecteur de retrait (220), dans lequel le détecteur de retrait (220) est adapté pour interagir avec le récipient d'échantillon de laboratoire (130) pour détecter un retrait du récipient d'échantillon de laboratoire (130) transporté du support de récipient d'échantillon (210), et
- dans lequel le système de laboratoire (200) est adapté pour déterminer sur la base du retrait détecté, qu'une attribution logique auparavant valide du support de récipient d'échantillon (210) au récipient d'échantillon de laboratoire (130) transporté est invalide, **caractérisé en ce que**
- le support de récipient d'échantillon (210) comprend un élément de mémoire (230), dans lequel l'élément de mémoire (230) est adapté pour stocker des informations sur la base du retrait détecté, des informations sur la base que l'attribution logique est valide et/ou des informations sur la base que l'attribution logique est invalide,
- le support de récipient d'échantillon (210) comprend un récepteur (241), dans lequel le récepteur (241) est adapté pour recevoir des informations sur la base que l'attribution logique est valide, et pour stocker les informations sur l'élément de mémoire (230),
- le support de récipient d'échantillon (200) comprend un transmetteur (242), dans lequel le transmetteur (242) est adapté pour transmettre des informations sur la base du retrait détecté, des informations sur la base que l'attribution logique est valide et/ou des informations que l'attribution logique est invalide,
- le support de récipient d'échantillon (210) comprend un transpondeur (240), dans lequel le transpondeur (240) comprend le transmetteur (242) et le récepteur (241) et dans lequel le transpondeur (240) est adapté pour recevoir une interrogation pour les informations et pour transmettre les informations en réponse à l'interrogation reçue,
- le transpondeur (240) est un transpondeur de communication en champ proche, et
- le récepteur (241) est adapté pour collecter de l'énergie et pour alimenter le support de récipient d'échantillon (210) avec l'énergie collectée.

2. Système de laboratoire (200) selon la revendication 1, dans lequel le détecteur de retrait (220) comprend :
- un commutateur (221), un capteur optique, un capteur capacitif, un capteur de pression, un capteur de température et/ou un alliage à mémoire de forme adaptés pour interagir avec le récipient d'échantillon de laboratoire (130) pour détecter un retrait du récipient d'échantillon de laboratoire (130) transporté du support de récipient d'échantillon (210).

3. Système de laboratoire (200) selon l'une quelconque des revendications précédentes, comprenant :
- une station réceptrice (330), dans lequel la station réceptrice (330) est adaptée pour recevoir des informations sur la base du retrait détecté, des informations sur la base que l'attribution logique est valide et/ou des informations que l'attribution logique est invalide, du support de récipient d'échantillon (210).

4. Système de laboratoire (200) selon l'une quelconque des revendications précédentes, comprenant :
- une station transmettrice (320), dans lequel la station transmettrice (320) est adaptée pour transmettre des informations, que l'attribution logique est valide, au support de récipient d'échantillon (210).

5. Système de laboratoire (200) selon l'une quelconque des revendications précédentes, comprenant :
- une station de lecteur de code-barres et d'attribution (310), dans lequel la station de lecteur de code-barres et d'attribution (310) est adaptée pour lire un code-barres (CB) du récipient d'échantillon de laboratoire (130) et pour attribuer logiquement le code-barres (CB) lu au récipient d'échantillon (210).

6. Système de laboratoire (200) selon l'une quelconque des revendications précédentes, comprenant :
- une station de chargement et d'attribution (300), dans lequel la station de chargement et d'attribution (300) est adaptée pour charger le récipient d'échantillon de laboratoire (130) sur le support de récipient d'échantillon (210) et pour déterminer que l'attribution logique du support de récipient d'échantillon (210) au récipient d'échantillon de laboratoire (130) chargé est valide.

7. Système de distribution d'échantillons de laboratoire (100) pour un système d'automatisation de laboratoire (10), comprenant :
- un système de laboratoire (200) selon l'une quelconque des revendications précédentes,
- un plan de transport (110), dans lequel le plan de transport (110) est adapté pour supporter le support de récipient d'échantillon (210),
- un certain nombre d'éléments d'entraînement (120), dans lequel le certain nombre d'éléments d'entraînement (120) est adapté pour déplacer le support de récipient d'échantillon (210) sur le plan de transport (110), et
- un dispositif de commande (125), dans lequel le dispositif de commande est configuré pour commander le certain nombre d'éléments d'entraînement (120), de telle sorte que le support de récipient d'échantillon (210) se déplace sur le plan de transport (110) le long d'un trajet de transport correspondant.

8. Système de distribution d'échantillons de laboratoire (100) selon la revendication 7,
- dans lequel le support de récipient d'échantillon (210) comprend un dispositif magnétiquement actif (215),
- dans lequel le certain nombre d'éléments d'entraînement (120) comprend un certain nombre d'actionneurs électromagnétiques (121), dans lequel le certain nombre d'actionneurs électromagnétiques (121) est disposé de manière stationnaire sous le plan de transport (110) et est adapté pour déplacer le support de récipient d'échantillon (210) sur le plan de transport (110) par application d'une force d'entraînement magnétique au support de récipient d'échantillon (210), et
- dans lequel le dispositif de commande (125) est configuré pour commander le certain nombre d'actionneurs électromagnétiques (121), de telle sorte que le support de récipient d'échantillon (210) se déplace sur le plan de transport (110) le long du trajet de transport correspondant.

9. Système d'automatisation de laboratoire (10), comprenant :
- un certain nombre de stations analytiques (20), dans lequel le certain nombre de stations analytiques (20) est adapté pour analyser un échantillon (139),
- un système de laboratoire (200) selon l'une quelconque des revendications 1 à 6 et/ou un système de distribution d'échantillons de laboratoire (100) selon la revendication 7 ou 8, dans lequel le système de distribution d'échantillons de laboratoire (100) est adapté pour déplacer le support de récipient d'échantillon (210) jusqu'au certain nombre de stations analytiques (20),
- dans lequel le système d'automatisation de laboratoire (10) est adapté pour empêcher l'analyse et/ou l'attribution de manière logique d'un résultat analytique à l'échantillon (139) contenu par le récipient d'échantillon de laboratoire (130) transporté sur la base de l'attribution logique invalide déterminée.
